# EUROPÄISCHE PATENTSCHRIFT

(11) **EP 4 081 372 B1**
(45) Veröffentlichungstag und Bekanntmachung des Hinweises auf die Patenterteilung: **18.06.2025**
(21) Anmeldenummer: 20807725.5
(22) Anmeldetag: 16.11.2020
(51) Int. Cl.: B25F 5/00, G05B 19/406, H02J 7/00, B25D 17/00

(54) **VERFAHREN ZU EINER INTERAKTION MIT ZUMINDEST EINEM BEDIENER EINES AKKUBETRIEBENEN BEARBEITUNGSGERÄTS SOWIE SYSTEM ZUR DURCHFÜHRUNG DES VERFAHRENS**
METHOD FOR INTERACTING WITH AT LEAST ONE USER OF A RECHARGEABLE-BATTERY-OPERATED MACHINING TOOL, AND SYSTEM FOR CARRYING OUT THE METHOD
PROCÉDÉ D'INTERACTION AVEC AU MOINS UN UTILISATEUR D'UN OUTIL D'USINAGE À BATTERIE RECHARGEABLE ET SYSTÈME DE MISE EN OEUVRE DU PROCÉDÉ

(30) Priorität: 27.12.2019 DE 102019220592
(43) Veröffentlichungstag der Anmeldung: 02.11.2022
(73) Patentinhaber: Robert Bosch GmbH, 70442 Stuttgart (DE)
(72) Erfinder: NICKLAUS, Mischa, 70193 Stuttgart (DE); KUEBLER, Helge, 72631 Aichtal (DE)
(86) Internationale Anmeldenummer: PCT/EP2020/082204
(87) Internationale Veröffentlichungsnummer: WO 2021/129979

(56) Entgegenhaltungen:
- US-A1- 2013 098 646
- US-A1- 2013 255 980
- US-A1- 2014 151 079

## Beschreibung

Die Erfindung betrifft ein Verfahren zu einer Interaktion mit zumindest einem Bediener eines akkubetriebenen Bearbeitungsgeräts sowie ein System zur Durchführung des Verfahrens nach der Gattung der unabhängigen Ansprüche.

### Stand der Technik

Akkubetriebene Bearbeitungsgeräte werden je nach ihrer vorgesehenen Verwendung in sehr unterschiedlichen Leistungsklassen angeboten. So gibt es beispielsweise Handwerkzeugmaschinen in unteren Leistungsklassen, die mit 10,8 V (nominell oftmals auch als 12 V bezeichnet) oder 14,4 V betrieben werden, während in den mittleren bis höheren Leistungsklassen überwiegend Bearbeitungsgeräte in Spannungsklassen von 18 V, 36 V, 54 V oder auch 72V zum Einsatz kommen. Die Spannungswerte resultieren dabei aus der Verschaltung (parallel oder seriell) der verwendeten Akkuzellen. Bevorzugt sind die Akkuzellen dabei als lithiumbasierte Akkuzellen, z.B. Li-Ion, Li-Po, Li-Metall oder dergleichen, mit einer Zellspannung von 3,6 V ausgebildet, wobei eine Akkuzelle in der Regel eine zylinderförmige Rundzelle ist, deren Zellpole an Enden der Zylinderform angeordnet sind. Die nachfolgende Erfindung ist jedoch nicht von der Art und Bauform der verwendeten Akkuzellen abhängig, sondern kann für beliebige Wechselackkupacks und Wechselakkus, z.B. neben Rundzellen auch Pouchzellen oder dergleichen, angewendet werden.

Um insbesondere in gewerblichen Anwendungen möglichst lange Betriebs- und kurze Pausenzeiten zu gewährleisten, haben sich bei vielen akkubetriebenen Bearbeitungsgeräten Wechselakkus bzw. Wechselakkupacks etabliert. Diese sind über entsprechende Schnittstellen an den Wechselakkupacks und den elektrischen Bearbeitungsgeräten kraft- und/oder formschlüssig lösbar miteinander verbunden. Unter einer ''lösbaren Verbindung" soll insbesondere eine werkzeuglos - also von Hand - lösbare und herstellbare Verbindung verstanden werden.

Aus der AU 2019200218 A1 ist eine akkubetriebene Elektrowerkzeugmaschine bekannt, die eine Steuer- oder Regelvorrichtung zur Steuerung bzw. Regelung eines elektrischen Antriebs für ein Einsatzwerkzeug aufweist. Die Steuer- oder Regelvorrichtung ist derart ausgestaltet, dass sie mit einer geräteexternen Einheit kommunizieren kann. Auf diese Weise kann eine Mehrzahl von akkubetriebenen Elektrowerkzeugmaschinen innerhalb desselben Netzwerks miteinander kommunizieren, um z.B. Daten über den Betrieb der Elektrowerkzeugmaschinen auszutauschen und ein einheitliches Steuer- oder Regelverhalten einzustellen. Unter anderem beinhalten die Daten auch eine Information über schwache und/oder leere Wechselakkupacks bzw. Wechselakkus.

Die US 2013/098646 A1 offenbart ein akkubetriebenses Bearbeitungsgerät, welches über einen Wechselakkupack mit Energie versorgbar ist. Es ist eine Alarmgenerierung und -anzeige vorgesehen, wenn das Bearbeitungsgerät über einen bestimmten, ersten Zeitraum unter hoher Last betrieben wird. Weiterhin erfolgt eine Unterbrechung der Stromversorgung, wenn der Betrieb unter hoher Last für einen zweiten Zeitraum, der länger ist als der erste Zeitraum, fortgeführt wird. Vergleichbare Ansätze sind auch aus der US 2014/151079 A1 und der US 2013/255980 bekannt.

Insbesondere akkubetriebene Bearbeitungsgeräte für Hochleistungsanwendungen benötigen Wechselakkupacks bzw. Wechselakkus mit entsprechend hohen Leistungsreserven und einer sehr hohen Stromlieferfähigkeit. Verwendet ein Bediener ein derartiges Bearbeitungsgerät in Verbindung mit einem Wechselakkupack bzw. Wechselakku mit zu geringer Stromlieferfähigkeit, so kann das akkubetriebene Bearbeitungsgerät seine Leistungsfähigkeit nicht voll ausschöpfen, was zu einem nicht zufriedenstellenden Arbeitsfortschritt für den Bediener führt. Zudem kann der Bediener den Eindruck erhalten, das akkubetriebene Bearbeitungsgerät sei defekt.

Es ist Aufgabe der Erfindung, die Interaktion eines Bedieners mit einem akkubetriebenen Bearbeitungsgerät derart zu verbessern, dass der Bediener bei mehrmaligem Überschreiten einer Leistungsgrenze zumindest eines in Verbindung mit dem akkubetriebenen Bearbeitungsgerät verwendeten Wechselakkupacks bzw. Wechselakkus zuverlässig informiert wird.

### Vorteile der Erfindung

Die Erfindung betrifft ein Verfahren zu einer Interaktion mit zumindest einem Bediener eines akkubetriebenen Bearbeitungsgeräts, das über zumindest einen Wechselakkupack bzw. Wechselakku mit Energie versorgbar ist. Zur Lösung der gestellten Aufgabe ist vorgesehen, dass in einem Verfahrensschritt mittels einer Erfassungseinheit des akkubetriebenen Bearbeitungsgeräts und/oder des zumindest einen Wechselakkupacks bzw. Wechselakkus zu definierten Zeitpunkten während des Betriebs des akkubetriebenen Bearbeitungsgeräts eine Leistungskenngröße des zumindest einen Wechselakkupacks bzw. Wechselakkus erfasst wird, wobei in einem weiteren Verfahrensschritt eine Häufigkeit berechnet wird, mit der der zumindest eine Wechselakkupack bzw. Wechselakku an seiner Leistungsgrenze betrieben wurde. In besonders vorteilhafter Weise kann der Bediener so über den Grund einer reduzierten Leistungsfähigkeit des akkubetriebenen Bearbeitungsgeräts und auf die Verwendung entsprechend leistungsfähiger Wechselakkupacks bzw. Wechselakkus hingewiesen werden. Herstellerseitig können damit Anfragen von Bedienern über eine beschränkte Leistungsfähigkeit von akkubetriebenen Bearbeitungsgeräten reduziert werden, was hilft, etwaige Servicekosten im Rahmen von Garantie- bzw. gesetzlichen Gewährleistungsansprüchen einzusparen.

Als akkubetriebene Bearbeitungsgeräte sollen im Kontext der Erfindung beispielweise Elektrowerkzeugmaschinen zur Bearbeitung von Werkstücken mittels eines elektrisch angetriebenen Einsatzwerkzeugs verstanden werden. Dabei kann die Elektrowerkzeugmaschine sowohl als Elektrohandwerkzeug als auch als stationäre Elektrowerkzeugmaschine ausgebildet sein. Typische Elektrowerkzeugmaschinen sind in diesem Zusammenhang Hand- oder Standbohrmaschinen, Hochleistungsschrauber, Schlagbohrmaschinen, Bohrhämmer, Hobel, Winkelschleifer, Schwingschleifer, Poliermaschinen, Kreis-, Tisch-, Kapp- und Stichsägen oder dergleichen. Als akkubetriebene Bearbeitungsgeräte kommen aber auch Gartengeräte wie Rasenmäher, Rasentrimmer, Astsägen oder dergleichen in Frage. Weiterhin ist die Erfindung auch für Wechselakkupacks bzw. Wechselakkus von akkubetriebenen Haushaltsgeräten, wie Staubsaugern, Mixer, etc. nutzbar.

Die Akkuspannung eines Wechselakkupacks ist in der Regel ein Vielfaches der Spannung einer einzelnen Akkuzelle und ergibt sich aus der Verschaltung (parallel oder seriell) der einzelnen Akkuzellen. Eine Akkuzelle ist typischerweise als eine galvanische Zelle ausgebildet, die einen Aufbau aufweist, bei dem ein Zellpol an einem Ende und ein weiterer Zellpol an einem gegenüberliegenden Ende zu liegen kommt. Insbesondere weist die Akkuzelle an einem Ende einen positiven Zellpol und an einem gegenüberliegenden Ende einen negativen Zellpol auf. Bevorzugt sind die Akkuzellen als lithiumbasierte Akkuzellen, z.B. Li-Ion, Li-Po, Li-Metall oder dergleichen, ausgebildet. Die Erfindung ist aber auch für Wechselakkupacks mit Ni-Cd-, Ni-MH-Zellen oder andere geeignete Zellenarten anwendbar. Bei gängigen Li-lon-Akkuzellen mit einer Zellspannung von 3,6 V ergeben sich beispielhaft Spannungsklassen von 3,6 V, 7,2 V, 10,8 V, 14,4 V, 18 V, 36 V etc. Bevorzugt ist eine Akkuzelle als zumindest im Wesentlichen zylinderförmige Rundzelle ausgebildet, wobei die Zellpole an Enden der Zylinderform angeordnet sind. Die Erfindung ist jedoch nicht von der Art und Bauform der verwendeten Akkuzellen abhängig, sondern kann auf beliebige Wechselackkupacks und Wechselakkus, z.B. neben Rundzellen auch Pouchzellen oder dergleichen, angewendet werden.

Es sei darüber hinaus angemerkt, dass die Ausgestaltung der elektromechanischen Schnittstellen der akkubetriebenen Bearbeitungsgeräte sowie die zugehörigen Aufnahmen zur kraft- und/oder formschlüssig lösbaren Verbindung der Wechselackkupacks nicht Gegenstand dieser Erfindung sein soll. Ein Fachmann wird je nach Leistungs- bzw. Spannungsklasse des akkubetriebenen Bearbeitungsgeräts und/oder der Wechselakkupacks eine geeignete Ausführungsform für die Schnittstelle wählen.

Zur Datenübertragung weist das akkubetriebene Bearbeitungsgerät eine Kommunikationsvorrichtung auf, mit der es die Daten an eine Kommunikationsvorrichtung einer geräteexternen Einheit, insbesondere eines Smartphones, eines Tablets, eines Computers, eines Cloud-Servers oder einer sonstigen Recheneinheit, sendet. Dabei erzeugt die geräteexterne Einheit in einem weiteren Verfahrensschritt auf Grundlage der die berechnete Häufigkeit enthaltenden Daten einen Hinweis für die Verwendung eines leistungsfähigeren Wechselakkupacks bzw. Wechselakkus. Dieser Hinweis kann dem zumindest einen Bediener in einem weiteren Verfahrensschritt mit einer Text-, Bild- und/oder Sprachnachricht, insbesondere als Push-Nachricht, angezeigt werden. Der Bediener kann auf diese Weise schnell, transparent und effizient auf die Problematik in Verbindung mit den von ihm eingesetzten Wechselakkupacks bzw. Wechselakkus hingewiesen werden und die Ursache durch den selbsttätigen Kauf leistungsstärkerer Wechselakkupacks bzw. Wechselakkus beseitigen.

Unter einer geräteexternen Einheit soll alles verstanden werden, was einerseits über eine entsprechende Kommunikationsvorrichtung mit dem akkubetriebenen Bearbeitungsgerät kommunizieren kann, und was andererseits insbesondere Energie autark und mechanisch entkoppelt vom akkubetriebenen Bearbeitungsgerät betrieben werden kann.

Die Kommunikationsvorrichtung des akkubetriebenen Bearbeitungsgeräts kann insbesondere als ein Funkmodul, beispielsweise als ein Bluetooth- oder Bluetooth-Low-Energy-Modul, als ein WLAN-, Infrarot-, LoRa-, NFC-Modul oder als eine andere, einem Fachmann als sinnvoll erscheinende kabellose Kommunikationsvorrichtung ausgebildet sein. Vorzugsweise ist die Kommunikationsvorrichtung ortsfest in einem Gehäuse des akkubetriebenen Bearbeitungsgeräts angeordnet, insbesondere lediglich unter Verwendung von Werkzeug von dem Gehäuse und/oder weiteren Bauteilen des akkubetriebenen Bearbeitungsgeräts lösbar. Die Kommunikationsvorrichtung der geräteexternen Einheit verfügt über dieselbe Funktechnologie, wie die Kommunikationsvorrichtung des akkubetriebenen Bearbeitungsgeräts. Da dem Fachmann entsprechende Kommunikationsvorrichtungen bekannt sind, soll an dieser Stelle nicht weiter darauf eingegangen werden.

Alternativ oder ergänzend ist vorgesehen, dass das akkubetriebene Bearbeitungsgerät eine interne Recheneinheit aufweist, die auf Grundlage der berechneten Häufigkeit in einem weiteren Verfahrensschritt einen Hinweis für die Verwendung eines leistungsfähigeren Wechselakkupacks bzw. Wechselakkus erzeugt. Dabei kann der Hinweis dem zumindest einen Bediener über eine Anzeigeeinheit des akkubetriebenen Bearbeitungsgeräts optisch, akustisch und/oder haptisch angezeigt werden. In besonders vorteilhafter Weise erfolgt somit die Anzeige über einen ggf. zu leistungsschwachen Wechselakkupack bzw. Wechselakku direkt durch das akkubetriebene Bearbeitungsgerät, so dass der Bediener bereits während der Bearbeitung eines Werkstücks über die Problematik informiert ist. Eine optische Anzeige kann dabei über Leuchtmittel (z.B. eine Mehrfarb-LED oder eine mehrstufige LED-Anzeige) und/oder ein Display (z.B. LCD, OLED, ePaper oder dergleichen) erfolgen.

Unter einer internen Recheneinheit soll insbesondere eine Einheit mit einem Prozessor und mit einem Speicher sowie mit einem in dem Speicher gespeicherten Betriebsprogramm verstanden werden. Vorzugsweise ist die interne Recheneinheit zumindest teilweise als ein Mikrocontroller ausgebildet oder umfasst zumindest einen Mikrocontroller mit einer Rechenleistung, die einen Betrieb eines Echtzeitbetriebssystems ermöglicht.

Der zumindest eine Bediener kann die Anzeige des Hinweises in einem weiteren Verfahrensschritt deaktivieren. Alternativ oder ergänzend ist auch möglich, dass die Anzeige des Hinweises nach einer definierten Anzahl von Wiederholungen in einem weiteren Verfahrensschritt deaktiviert wird. Dies lässt einerseits darauf schließen, dass der zumindest eine Bediener den Hinweis bewusst ignoriert hat, um mit dem akkubetriebenen Bearbeitungsgerät trotz verminderter Leistungsfähigkeit weiterarbeiten zu können. Andererseits erlaubt das aktive Deaktivieren des Hinweises auch, dass der zumindest eine Bediener eine zu häufige Benachrichtigung nicht als störend empfindet. Es kann weiterhin vorgesehen sein, dass der Hinweis nach einer definierten Zeitspanne, in der er nicht angezeigt wurde, automatisch wieder angezeigt wird und/oder dass der Hinweis an andere Bediener des akkubetriebenen Bearbeitungsgeräts weitergeleitet werden kann. Dies ist insbesondere vorteilhaft, wenn mehrere Bediener dasselbe akkubetriebene Bearbeitungsgerät benutzen.

Auch kann vorgesehen sein, dass der zumindest eine Bediener das akkubetriebene Bearbeitungsgerät derart einstellen kann, dass es zumindest für einen definierten Zeitraum nur mit an die Leistungsgrenze des zumindest einen Wechselakkupacks bzw. Wechselakkus angepasster, verminderter Leistung betreibbar ist. Auf diese Weise kann der Bediener den Stromverbrauch des akkubetriebenen Geräts an den verwendeten Wechselakkupack anpassen. Zudem kann so vermieden werden, dass der Wechselakkupack bzw. Wechselakku dauerhaft zum Beispiel durch Überhitzung seine maximale Ladekapazität verliert.

Die Erfindung betrifft ferner ein System mit einem akkubetriebenen Bearbeitungsgerät und einem Wechselakkupack bzw. Wechselakku zur Durchführung des erfindungsgemäßen Verfahrens, wobei eine Erfassungseinheit des akkubetriebenen Bearbeitungsgeräts und/oder des zumindest einen Wechselakkupacks bzw. Wechselakkus zu definierten Zeitpunkten während des Betriebs des akkubetriebenen Bearbeitungsgeräts eine Leistungskenngröße des zumindest einen Wechselakkupacks bzw. Wechselakkus erfasst und eine Recheneinheit des ackubetriebenen Bearbeitungsgeräts eine Häufigkeit berechnet, mit der der zumindest eine Wechselakkupack bzw. Wechselakku an seiner Leistungsgrenze betrieben wurde.

In Verbindung mit einer geräteexternen Einheit, insbesondere einem Smartphone, einem Tablet, einem Computer, einem Cloud-Server oder einer sonstigen Recheneinheit, kann vorgesehen sein, dass einzelne Verfahrensschritte des Verfahrens auf der geräteexternen Einheit durchgeführt werden. Letzteres erlaubt einerseits die Verwendung von akkubetriebenen Geräten ohne aufwändige und teure interne Recheneinheit und andererseits die einfache Verarbeitung und Weitergabe der Informationen durch ein entsprechendes Backend selbst bei ausgeschaltetem akkubetriebenen Bearbeitungsgerät. Zudem können auf diese Weise schnell und effizient mehrere Bediener des akkubetriebenen Bearbeitungsgeräts über die berechnete Häufigkeit, mit der der zumindest eine Wechselakkupack bzw. Wechselakku an seiner Leistungsgrenze betrieben wurde, informiert werden.

### Ausführungsbeispiele

### Zeichnung

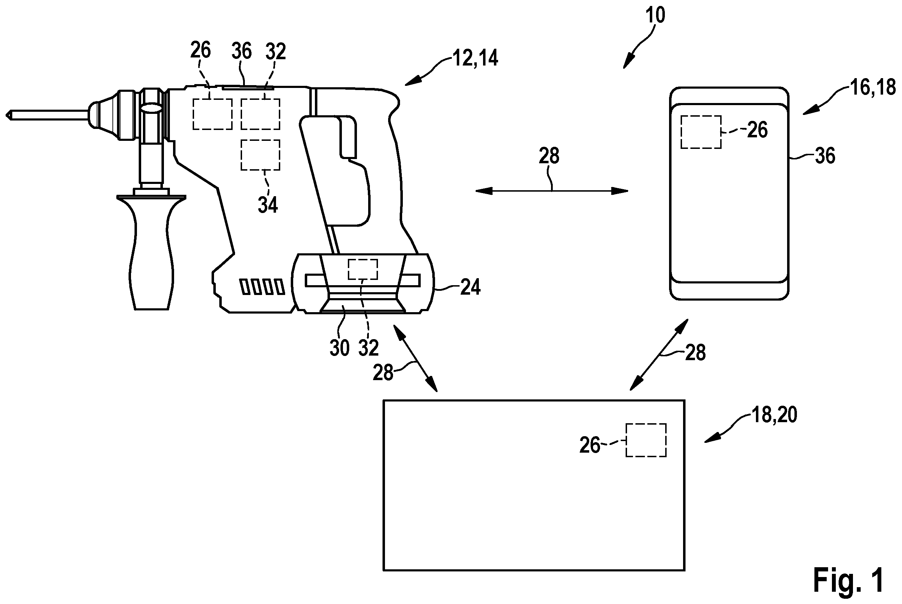

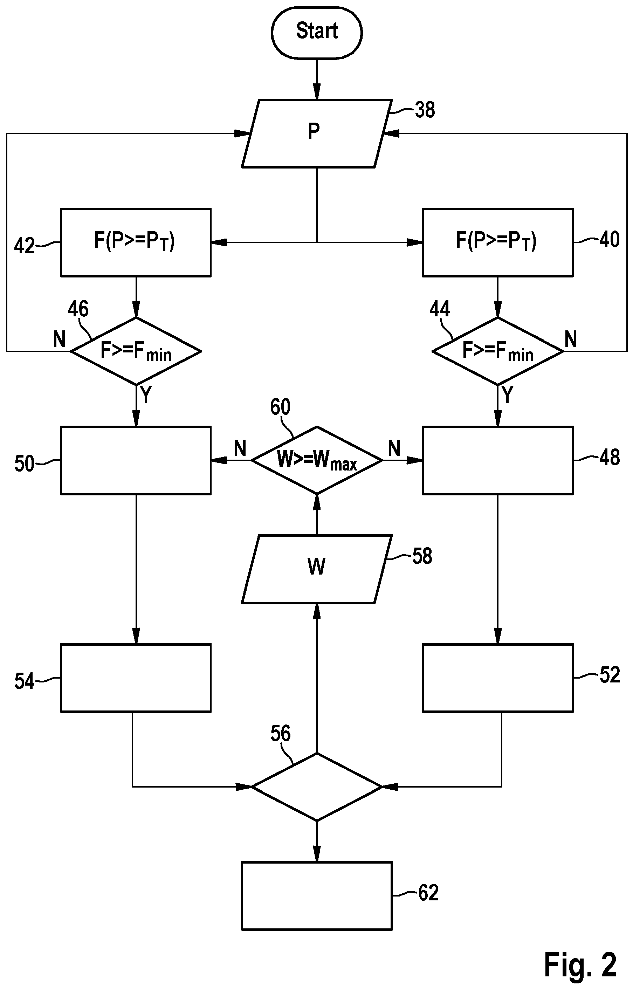

Die Erfindung wird im Folgenden anhand der Figuren 1 und 2 beispielhaft erläutert, wobei gleiche Bezugszeichen in den Figuren auf gleiche Bestandteile mit einer gleichen Funktionsweise hindeuten.

Es zeigen
- Fig.1: eine schematische Darstellung eines erfindungsgemäßen Systems zur Durchführung des erfindungsgemäßen Verfahrens zu einer Interaktion mit zumindest einem Bediener eines akkubetriebenen Bearbeitungsgeräts und
- Fig. 2:: ein Ablaufdiagramm des erfindungsgemäßen Verfahrens zu einer Interaktion mit zumindest einem Bediener eines akkubetriebenen Bearbeitungsgeräts.

### Beschreibung der Ausführungsbeispiele

In Figur 1 ist ein System 10 aus einem als Akkubohrhammer 12 ausgebildeten akkubetriebenen Bearbeitungsgerät 14, einer als Smartphone 16 ausgebildeten ersten geräteexternen Einheit 18 und einer als loT- bzw. Cloud-Server 20 ausgebildeten zweiten geräteexternen Einheit 18 gezeigt. Es sind aber auch andere Ausgestaltungen des Systems 10, insbesondere in Art und Anzahl der akkubetriebenen Bearbeitungsgeräte 14 sowie der geräteexternen Einheiten 18 denkbar.

Der Akkubohrhammer 12 wird über zumindest einen Wechselakkupack bzw. Wechselakku 24 mit Energie versorgt. Bei dem Wechselakkupack bzw. Wechselakku 24 handelt es sich um einen herkömmlichen Wechselakkupack bzw. Wechselakku mit einem Gehäuse 30, das an einer ersten Seitenwand eine nicht näher gezeigte elektromechanische Schnittstelle zur lösbaren Verbindung mit einer ebenfalls nicht näher gezeigten Akkuschnittstelle des Akkubohrhammers 12 und mit einem nicht gezeigten Ladegerät aufweist. In Verbindung mit dem Akkubohrhammer 12 dient die elektromechanische Schnittstelle des zumindest einen Wechselakkupacks 24 zum Entladen, während sie in Verbindung mit dem Ladegerät ein Aufladen des zumindest einen Wechselakkupacks 24 ermöglicht. Das Aufladen kann aber alternativ oder ergänzend auch direkt über die Akkuschnittstelle des Akkubohrhammers 12 erfolgen. Die genaue Ausgestaltung der elektromechanischen Schnittstelle und der Akkuschnittstelle ist abhängig von verschiedenen Faktoren, wie beispielsweise der Spannungsklasse der Wechselackupacks 24 oder diversen Herstellerspezifikationen. So können z.B. zwei oder mehr elektrische Kontakte zur Energie- und/oder Datenübertragung zwischen dem zumindest einen Wechselakkupack 24 und dem Akkubohrhammer 12 bzw. dem Ladegerät vorgesehen sein. Auch ist eine mechanische Kodierung denkbar, so dass der zumindest eine Wechselakkupack 24 nur an bestimmten akkubetriebenen Bearbeitungsgeräten 14 betreibbar ist. Da die genaue Ausgestaltung der elektromechanischen Schnittstelle für die Erfindung unerheblich ist, soll hierauf nicht weiter im Detail eingegangen werden. Sowohl ein Fachmann als auch ein Bediener des akkubetriebenen Bearbeitungsgeräts 14 werden diesbezüglich die geeignete Auswahl treffen.

Die einzelnen Komponenten des Systems 10 weisen jeweils eine Kommunikationsvorrichtung 26 auf, die zu einer Datenübertragung 28 innerhalb des Systems 10, insbesondere zwischen dem akkubetriebenen Bearbeitungsgerät 14, der ersten geräteexternen Einheit 18 und der zweiten geräteexternen Einheit 18 vorgesehen sind. Die Kommunikationsvorrichtungen 26 können beispielsweise für eine Übertragung von WLAN- und/oder Bluetooth-Protokollen ausgebildet sein. So ist es denkbar, dass Daten zwischen dem akkubetriebenen Bearbeitungsgerät 14 und der als Smartphone 16 ausgebildeten ersten geräteexternen Einheit 18 per Bluetooth ausgetauscht werden, während die erste und die zweite geräteexterne Einheit 18 über ihre jeweiligen Kommunikationsvorrichtungen 26 per WLAN oder auch per kabelgebundener Ethernet-Verbindung miteinander kommunizieren. Es sind auch andere Ausgestaltungen der Kommunikationsvorrichtungen 26 denkbar, beispielsweise zur Datenübertragung per LoRa, NFC oder dergleichen oder aber auch per optischer oder akustischer Kopplung. Zudem ist denkbar, dass die erste und die zweite geräteexterne Einheit 18 über eine Internetverbindung kommunizieren. Dies ist beispielsweise dann der Fall, wenn die zweite geräteexterne Einheit 18 als ein entfernt positionierter Cloud-Server 20 ausgebildet ist. Dem Fachmann sind die verschiedenen und vielfältigen Ausgestaltungsmöglichkeiten der ersten und der zweiten geräteexternen Einheit 18 bekannt, so dass hier nicht weiter darauf eingegangen werden soll.

Der Akkubohrhammer 12 umfasst eine Erfassungseinheit 32, die zu definierten Zeitpunkten während des Betriebs des Akkubohrhammers 12 eine Leistungskenngröße P des zumindest einen Wechselakkupacks bzw. Wechselakkus 24 erfasst. Die Erfassungseinheit 32 kann zu diesem Zweck zumindest ein Sensorelement aufweisen, das jedoch in den Figuren nicht näher gezeigt ist. Das Sensorelement ist beispielsweise als ein Shunt-Widerstand oder ein anderes zur Erfassung der Leistungskenngröße P des zumindest einen Wechselakkupacks bzw. Wechselakkus 24 geeignetes Sensorelement für eine Strom-, Spannungs- und/oder Temperaturmessung ausgebildet. Dabei ergibt sich eine Leistungsgrenze P_{T} des Wechselakkupacks bzw. Wechselakkus 24 in der Regel aus seiner maximalen Stromlieferfähigkeit unter Einhaltung der Temperaturgrenzwerte. Zudem kann der Wechselakkupack bzw. Wechselakku 24 seine Leistungsgrenze P_{T} und ggf. weitere akkuspezifische Parameter per Codierwiderstand oder anderer geeigneter Mittel über seine elektromechanische Schnittstelle und die Akkuschnittstelle des Akkubohrhammer 12 an den Akkubohrhammer 12 übertragen. Alternativ oder ergänzend ist es auch möglich, dass die Erfassung der Leistungskenngröße P innerhalb des Wechselakkupacks bzw. Wechselakkus 24 mittels einer entsprechenden Erfassungseinheit 32 erfolgt. Weiterhin umfasst der Akkubohrhammer 12 eine interne Recheneinheit 34 zur Berechnung bzw. Erfassung einer Häufigkeit **F,** mit der der zumindest eine Wechselakkupack bzw. Wechselakku 24 an seiner Leistungsgrenze P_{T} betrieben wurde.

Zumindest eine der geräteexternen Einheiten 18 und/oder das akkubetriebene Bearbeitungsgerät 14 weisen eine Anzeigeeinheit 36 zur Ausgabe von optischen, akustischen und/oder haptischen Signalen auf. Eine optische Ausgabe kann dabei über Leuchtmittel (z.B. eine Mehrfarb-LED oder eine mehrstufige LED-Anzeige) und/oder ein Display (z.B. LCD, OLED, ePaper oder dergleichen) erfolgen, während zur akustischen Ausgabe beispielsweise ein Lautsprecher und zur haptischen Ausgabe ein Vibrationsmotor dient.

In Figur 2 ist ein beispielhafter Ablauf des erfindungsgemäßen Verfahrens zu einer Interaktion mit zumindest einem Bediener des Akkubohrhammers 12 mittels des Systems 10 gezeigt. Dabei wird rechtsseitig die Abarbeitung der einzelnen Verfahrensschritte in der geräteexternen Einheit 18 und linksseitig die Abarbeitung der entsprechenden Verfahrensschritte im Akkubohrhammer 12 bzw. im ackubetriebenen Bearbeitungsgerät 10 gezeigt. In einem Verfahrensschritt 38 wird mittels der Erfassungseinheit 32 des Bohrhammers 12 und/oder des zumindest einen Wechselakkupacks bzw. Wechselakkus 24 zu definierten Zeitpunkten während des Betriebs des Bohrhammers 12 eine Leistungskenngröße P des zumindest einen Wechselakkupacks bzw. Wechselakkus 24 erfasst. Die Leistungskenngröße P wird sodann mittels der Kommunikationsvorrichtung 26 des Akkubohrhammers 12 an die Kommunikationsvorrichtung 26 der zumindest einen geräteexternen Einheit 18, beispielsweise des Smartphones 16, übertragen. In einem weiteren Verfahrensschritt 40 wird anschließend die Häufigkeit F berechnet, mit der der zumindest eine Wechselakkupack bzw. Wechselakku 24 an seiner Leistungsgrenze P_{T} betrieben wurde. Dabei kann ''an seiner Leistungsgrenze" ausgelegt werden als ein Erreichen oder Überschreiten der Leistungsgrenze (P >= P_{T}) oder als ein reines Überschreiten der Leistungsgrenze (P > P₇). Ebenso ist es denkbar, als Schwellwert für die Häufigkeit F ein ungefähres Erreichen der Leistungsgrenze mit F(P ≅ P_{T}) zu definieren. Alternativ oder ergänzend kann auch vorgesehen sein, dass die Häufigkeit F in einem Verfahrensschritt 42 durch die im Akkubohrhammer 12 integrierte Recheneinheit 34 berechnet wird. Die Leistungsgrenze P_{T} des mit dem Akkubohrhammer 12 verbundenen Wechselackupacks bzw. Wechselakkus 24 kann dazu dem Akkubohrhammer 12 durch den Wechselakkupack bzw. Wechselakku 24 in der beschriebenen Art und Weise übermittelt worden sein. Zudem kann der Akkubohrhammer 12 diesen Wert über seine Kommunikationsvorrichtung 26 an die geräteexterne Einheit 18 senden.

So lange eine definierte Mindesthäufigkeit Fₘᵢₙ nicht überschritten oder erreicht wurde, wird die Leistungkenngröße P gemäß der Schritte 44 bzw. 46 weiter erfasst. Bei Überschreiten oder Erreichen der Mindesthäufigkeit durch die berechnete Häufigkeit (F >= Fₘᵢₙ) wird in den Schritten 48 bzw. 50 ein Hinweis für die Verwendung eines leistungsfähigeren Wechselakkupacks bzw. Wechselakkus 24 erzeugt. Dieser Hinweis kann dem zumindest einen Bediener in einem weiteren Verfahrensschritt 52 mit einer Text-, Bild- und/oder Sprachnachricht, insbesondere als Push-Nachricht, auf der geräteexternen Einheit 18 angezeigt werden. Der Bediener kann auf diese Weise schnell, transparent und effizient über den Grund einer reduzierten Leistungsfähigkeit des Akkubohrhammers 12 und auf die Verwendung entsprechend leistungsfähiger Wechselakkupacks bzw. Wechselakkus 24 hingewiesen werden. Für den Hersteller des Akkubohrhammers ergibt sich überdies der Vorteil, dass sich die Anzahl möglicher Anfragen von Bedienern über eine beschränkte Leistungsfähigkeit entsprechender akkubetriebener Bearbeitungsgeräte 114 infolge des Verwendens zu leistungsschwacher Wechselackupacks bzw. Wechselakkus reduziert. Somit lassen sich etwaige Servicekosten im Rahmen von Garantie- bzw. gesetzlichen Gewährleistungsansprüchen einsparen.

Auf Grundlage der erfassten Häufigkeit F kann auch die interne Recheneinheit 34 des Akkubohrhammers 12 in einem weiteren Verfahrensschritt 54 einen Hinweis für die Verwendung eines leistungsfähigeren Wechselakkupacks bzw. Wechselakkus 24 erzeugen. Dieser Hinweis kann dem zumindest einen Bediener beispielsweise mittels der Anzeigeeinheit 36 des Akkubohrhammers 12 optisch, akustisch und/oder haptisch ausgegeben werden.

Der zumindest eine Bediener kann die Anzeige des Hinweises in einem weiteren Verfahrensschritt 56 deaktivieren. Alternativ oder ergänzend ist auch möglich, dass die Anzeige des Hinweises nach einer definierten Maximalanzahl von Wiederholungen Wₘₐₓ in einem weiteren Verfahrensschritt 60 deaktiviert wird. Dies gibt dem Bediener die Möglichkeit, den Hinweis bzw. dessen regelmäßige Wiederholung W bewusst zu unterdrücken, um mit dem Akkubohrhammer 12 trotz verminderter Leistungsfähigkeit weiterarbeiten zu können. Zudem kann vorgesehen sein, den Hinweis nach einer definierten Zeitspanne, in der er nicht angezeigt wurde, automatisch wieder anzuzeigen und/oder an andere Bediener des Akkubohrhammers 12 weiterzuleiten. Dies ist insbesondere vorteilhaft, wenn mehrere Bediener den Akkubohrhammer im Wechsel benutzen.

Schließlich kann das erfindungsgemäße Verfahren ein vorsehen, dass der zumindest eine Bediener den Akkubohrhammer 12 in einem weiteren Verfahrensschritt 62 derart einstellen kann, dass es zumindest für einen definierten Zeitraum nur mit an die Leistungsgrenze P_{T} des zumindest einen Wechselakkupacks bzw. Wechselakkus 24 angepasster, verminderter Leistung betreibbar ist. Auf diese Weise kann der Bediener den Stromverbrauch des Akkubohrhammers 12 an den verwendeten Wechselakkupack 24 anpassen, um diesen nicht dauerhaft zu beschädigen.

## Patentansprüche

1. Verfahren zu einer Interaktion mit zumindest einem Bediener eines akkubetriebenen Bearbeitungsgeräts (14), das über zumindest einen Wechselakkupack bzw. Wechselakku (24) mit Energie versorgbar ist, wobei in einem Verfahrensschritt (38) mittels einer Erfassungseinheit (32) des akkubetriebenen Bearbeitungsgeräts (14) und/oder des zumindest einen Wechselakkupacks bzw. Wechselakkus (24) zu definierten Zeitpunkten während des Betriebs des akkubetriebenen Bearbeitungsgeräts (14) eine Leistungskenngröße (P) des zumindest einen Wechselakkupacks bzw. Wechselakkus (24) erfasst wird, und wobei in einem weiteren Verfahrensschritt (40, 42) eine Häufigkeit (F) berechnet wird, mit der der zumindest eine Wechselakkupack bzw. Wechselakku (24) an seiner Leistungsgrenze (P_{T}) betrieben wurde.

2. Verfahren nach Anspruch 1, **dadurch gekennzeichnet, dass** das akkubetriebene Bearbeitungsgerät (14) eine Kommunikationsvorrichtung (26) aufweist, mit der es insbesondere kabellos Daten an eine Kommunikationsvorrichtung (26) einer geräteexternen Einheit (18), insbesondere eines Smartphones (16), eines Tablets, eines Computers, eines Cloud-Servers (20) oder einer sonstigen Recheneinheit, sendet, wobei die geräteexterne Einheit (18) in einem weiteren Verfahrensschritt (48) auf Grundlage der die berechnete Häufigkeit (F) enthaltenden Daten einen Hinweis für die Verwendung eines leistungsfähigeren Wechselakkupacks bzw. Wechselakkus (24) erzeugt.

3. Verfahren nach Anspruch 2, **dadurch gekennzeichnet, dass** der Hinweis dem zumindest einen Bediener in einem weiteren Verfahrensschritt (52) mit einer Text-, Bild- und/oder Sprachnachricht, insbesondere als Push-Nachricht, angezeigt wird.

4. Verfahren nach einem der vorhergehenden Ansprüche, **dadurch gekennzeichnet, dass** das akkubetriebene Bearbeitungsgerät (14) eine interne Recheneinheit (34) aufweist, die auf Grundlage der berechneten Häufigkeit (F) in einem weiteren Verfahrensschritt (50) einen Hinweis für die Verwendung eines leistungsfähigeren Wechselakkupacks bzw. Wechselakkus (24) erzeugt.

5. Verfahren nach einem der vorhergehenden Ansprüche 2 bis 4, **dadurch gekennzeichnet, dass** der zumindest eine Hinweis dem zumindest einen Bediener über eine Anzeigeeinheit (36) des akkubetriebenen Bearbeitungsgeräts (14) optisch, akustisch und/oder haptisch angezeigt wird.

6. Verfahren nach einem der vorhergehenden Ansprüche 3 oder 5, **dadurch gekennzeichnet, dass** der zumindest eine Bediener die Anzeige des Hinweises in einem weiteren Verfahrensschritt (56) deaktivieren kann.

7. Verfahren nach einem der vorhergehenden Ansprüche 3, 5 oder 6, **dadurch gekennzeichnet, dass** die Anzeige des Hinweises nach einer definierten Anzahl von Wiederholungen (W) in einem weiteren Verfahrensschritt (60) deaktiviert wird.

8. Verfahren nach einem der vorhergehenden Ansprüche, **dadurch gekennzeichnet, dass** der zumindest eine Bediener das akkubetriebene Bearbeitungsgerät (14) in einem weiteren Verfahrensschritt (62) derart einstellen kann, dass es zumindest für einen definierten Zeitraum nur mit an die Leistungsgrenze (P_{T}) des zumindest einen Wechselakkupacks bzw. Wechselackus (24) angepasster, verminderter Leistung betreibbar ist.

9. System (10) mit einem akkubetriebenen Bearbeitungsgerät (14) und einem Wechselakkupack bzw. Wechselakku (24) zur Durchführung des Verfahrens nach einem der vorhergehenden Ansprüche, wobei eine Erfassungseinheit (32) des akkubetriebenen Bearbeitungsgeräts (14) und/oder des zumindest einen Wechselakkupacks bzw. Wechselakkus (24) zu definierten Zeitpunkten während des Betriebs des akkubetriebenen Bearbeitungsgeräts (14) eine Leistungskenngröße (P) des zumindest einen Wechselakkupacks bzw. Wechselakkus (24) erfasst und eine Recheneinheit (34) des akkubetriebenen Bearbeitungsgeräts (14) eine Häufigkeit (F) berechnet, mit der der zumindest eine Wechselakkupack bzw. Wechselakku (24) an seiner Leistungsgrenze (P_{T}) betrieben wurde.

## Claims

1. Method for interacting with at least one user of a rechargeable-battery-operated machining tool (14), which is able to be supplied with energy by means of at least one exchangeable rechargeable battery pack or exchangeable rechargeable battery (24), wherein in one method step (38) a power characteristic variable (P) of the at least one exchangeable rechargeable battery pack or exchangeable rechargeable battery (24) is sensed by means of a sensing unit (32) of the rechargeable-battery-operated machining tool (14) and/or of the at least one exchangeable rechargeable battery pack or exchangeable rechargeable battery (24) at defined points in time during the operation of the rechargeable-battery-operated machining tool (14), and wherein in a further method step (40, 42) a frequency (F) with which the at least one exchangeable rechargeable battery pack or exchangeable rechargeable battery (24) has been operated at its power limit (P_{T}) is calculated.

2. Method according to Claim 1, **characterized in that** the rechargeable-battery-operated machining tool (14) comprises a communication device (26), by way of which said tool transmits, in particular wirelessly, data to a communication device (26) of a tool-external unit (18), in particular of a smartphone (16), of a tablet, of a computer, of a cloud server (20) or of some other computing unit, wherein in a further method step (48) the tool-external unit (18) generates advice for the use of a more powerful exchangeable rechargeable battery pack or exchangeable rechargeable battery (24) on the basis of the data containing the calculated frequency (F).

3. Method according to Claim 2, **characterized in that** the advice is indicated to the at least one user in a further method step (52) by way of a text, image and/or voice message, in particular as a push message.

4. Method according to any of the preceding claims, **characterized in that** the rechargeable-battery-operated machining tool (14) comprises an internal computing unit (34), which generates advice for the use of a more powerful exchangeable rechargeable battery pack or exchangeable rechargeable battery (24) on the basis of the calculated frequency (F) in a further method step (50).

5. Method according to any of the preceding Claims 2 to 4, **characterized in that** the at least one piece of advice is indicated to the at least one user visually, acoustically and/or haptically by means of an indicator unit (36) of the rechargeable-battery-operated machining tool (14).

6. Method according to either of the preceding Claims 3 and 5, **characterized in that** the at least one user can deactivate the indication of the advice in a further method step (56).

7. Method according to any of the preceding Claims 3, 5 and 6, **characterized in that** the indication of the advice is deactivated after a defined number of repetitions (W) in a further method step (60).

8. Method according to any of the preceding claims, **characterized in that** the at least one user can set the rechargeable-battery-operated machining tool (14) in a further method step (62) in such a way that said tool is operable at least for a defined time period only with reduced power adapted to the power limit (P_{T}) of the at least one exchangeable rechargeable battery pack or exchangeable rechargeable battery (24).

9. System (10) comprising a rechargeable-battery-operated machining tool (14) and an exchangeable rechargeable battery pack or exchangeable rechargeable battery (24) for carrying out the method according to any of the preceding claims, wherein a sensing unit (32) of the rechargeable-battery-operated machining tool (14) and/or of the at least one exchangeable rechargeable battery pack or exchangeable rechargeable battery (24) senses a power characteristic variable (P) of the at least one exchangeable rechargeable battery pack or exchangeable rechargeable battery (24) at defined points in time during the operation of the rechargeable-battery-operated machining tool (14), and a computing unit (34) of the rechargeable-battery-operated machining tool (14) calculates a frequency (F) with which the at least one exchangeable rechargeable battery pack or exchangeable rechargeable battery (24) has been operated at its power limit (P_{T}).

## Revendications

1. Procédé d'interaction avec au moins un utilisateur d'un outil d'usinage alimenté par batterie rechargeable (14), qui peut être alimenté en énergie au moyen d'au moins un bloc-batterie rechargeable interchangeable ou d'une batterie rechargeable interchangeable (24), dans lequel, lors d'une étape de procédé (38), une variable de caractéristique de puissance (P) dudit au moins un bloc-batterie rechargeable interchangeable ou de ladite au moins une batterie rechargeable interchangeable (24) est détectée au moyen d'une unité de détection (32) de l'outil d'usinage alimenté par batterie rechargeable (14) et/ou dudit au moins un bloc-batterie rechargeable interchangeable ou de ladite au moins une batterie rechargeable interchangeable (24) à des instants définis pendant le fonctionnement de l'outil d'usinage alimenté par batterie rechargeable (14), et dans lequel, lors d'une étape supplémentaire de procédé (40, 42), la fréquence (F) à laquelle ledit au moins un bloc-batterie rechargeable interchangeable ou ladite au moins une batterie rechargeable interchangeable (24) a été actionné à sa limite de puissance (P_{T}) est calculée.

2. Procédé selon la revendication 1, **caractérisé en ce que** l'outil d'usinage alimenté par batterie rechargeable (14) comporte un dispositif de communication (26) avec lequel il envoie, en particulier sans fil, des données à un dispositif de communication (26) d'une unité externe à l'appareil (18), en particulier un téléphone intelligent (16), une tablette, un ordinateur, un serveur en nuage (20) ou une autre unité de calcul, dans lequel l'unité externe à l'appareil (18) génère, lors d'une étape supplémentaire de procédé (48), sur la base des données contenant la fréquence calculée (F), une indication pour l'utilisation d'un bloc-batterie rechargeable interchangeable ou d'une batterie rechargeable interchangeable (24) plus performant.

3. Procédé selon la revendication 2, **caractérisé en ce que** l'indication est affichée à l'attention dudit au moins un utilisateur lors d'une étape supplémentaire de procédé (52) avec un message textuel, par image et/ou vocal, en particulier sous forme de notification de type push.

4. Procédé selon l'une quelconque des revendications précédentes, **caractérisé en ce que** l'outil d'usinage alimenté par batterie rechargeable (14) comporte une unité de calcul interne (34) qui génère, lors d'une étape supplémentaire de procédé (50), sur la base de la fréquence calculée (F), une indication pour l'utilisation d'un bloc-batterie rechargeable interchangeable ou d'une batterie rechargeable interchangeable (24) plus performant.

5. Procédé selon l'une quelconque des revendications 2 à 4 précédentes, **caractérisé en ce que** ladite au moins une indication est affichée à l'attention dudit au moins un utilisateur au moyen d'une unité d'affichage (36) de l'outil d'usinage alimenté par batterie rechargeable (14) de manière optique, acoustique et/ou haptique.

6. Procédé selon l'une quelconque des revendications 3 ou 5 précédentes, **caractérisé en ce que** ledit au moins un utilisateur peut désactiver l'affichage de l'indication lors d'une étape supplémentaire de procédé (56).

7. Procédé selon l'une quelconque des revendications 3, 5 ou 6 précédentes, **caractérisé en ce que** l'affichage de l'indication est désactivé lors d'une étape supplémentaire de procédé (60) après un nombre défini de répétitions (W).

8. Procédé selon l'une quelconque des revendications précédentes, **caractérisé en ce que** ledit au moins un utilisateur peut régler l'outil d'usinage alimenté par batterie rechargeable (14), lors d'une étape supplémentaire de procédé (62), de telle sorte qu'il ne puisse être actionné, au moins pendant une période définie, qu'avec une puissance réduite adaptée à la limite de puissance (P_{T}) dudit au moins un bloc-batterie rechargeable interchangeable ou de ladite au moins une batterie rechargeable interchangeable (24).

9. Système (10) comprenant un outil d'usinage à batterie rechargeable (14) et un bloc-batterie rechargeable interchangeable ou une batterie rechargeable interchangeable (24) pour la mise en œuvre du procédé selon l'une quelconque des revendications précédentes, dans lequel une unité de détection (32) de l'outil d'usinage alimenté par batterie rechargeable (14) et/ou dudit au moins un bloc-batterie rechargeable interchangeable ou de ladite au moins une batterie rechargeable interchangeable (24) détecte, à des instants définis pendant le fonctionnement de l'outil d'usinage alimenté par batterie rechargeable (14), une variable de caractéristique de puissance (P) dudit au moins un bloc-batterie rechargeable interchangeable ou de ladite au moins une batterie rechargeable interchangeable (24), et une unité de calcul (34) de l'outil d'usinage alimenté par batterie rechargeable (14) calcule une fréquence (F) à laquelle ledit au moins un bloc-batterie rechargeable interchangeable ou ladite au moins une batterie rechargeable interchangeable (24) a été actionné à sa limite de puissance (P_{T}).
